# EUROPEAN PATENT APPLICATION

(11) **EP 3 034 182 A1**
(43) Date of publication of application: **22.06.2016**
(21) Application number: 14198615.8
(22) Date of filing: 17.12.2014
(51) Int. Cl.: B05D 3/04, B05D 7/00, B05D 1/26

(54) **Coating system and coating method**

(71) Applicant: Nederlandse Organisatie voor toegepast- natuurwetenschappelijk onderzoek TNO, 2595 DA 's-Gravenhage (NL)
(72) Inventor: de Vries, Ike Gerke, 2628 VK Delft (NL); Unnikrishnan, Sandeep, 2628 VK Delft (NL); Manders, Wilhelmus Hubertus, 2628 VK Delft (NL); Smeltink, Jeroen Anthonius, 2628 VK Delft (NL); Toonen, Leonardus Maria, 2628 VK Delft (NL)
(74) Representative: V.O.

(57) **Abstract**

A coating system (1) is provided comprising a coating chamber (20) having arranged therein a coating apparatus (10) for providing a substrate (S) with an organic coating layer. The coating apparatus (10) comprises a coating device (12) for depositing a solvent free, curable organic precursor for said organic coating layer and a curing unit (14) for curing the organic precursor deposited on said substrate (S) by supplying energy to said organic precursor. The coating system further comprises a vacuum pump (30) that, while coating, maintains a pressure inside said coating chamber below 1 mbar. A supply facility (152, 152') for controllably supplies the curable organic precursor from the reservoir to the coating device (12), The supply facility (152, 152') has an input (1510) for receiving curable organic precursor from the reservoir. A position of a bottom (150B) of the reservoir is arranged at a height (H1) above the input (1510). The coating system has a first operational mode wherein curable organic precursor to be supplied to the coating apparatus is exposed to a vacuum having a pressure with a first pressure value that is equal to or lower than the chamber pressure value, and has a second operational mode following the first operational mode, wherein the supply facility (152, 152') supplies the curable organic precursor to the coating device (12).

## Description

### BACKGROUND OF THE INVENTION

### Field of the invention

The present invention relates to a coating system.

The present invention further relates to a coating method.

### Related Art

For many products it is desirable to provide coated substrates having a plurality of coating layers of a mutually different nature. Due to their mutually different nature, they require mutually different coating techniques. It is desired however that these coating techniques can be subsequently applied in a continuous manner, i.e. without requiring intermediate storage of the substrate between subsequent coating steps.

In this respect reference is made to WO2011028119A1, which describes an apparatus for coating a flexible substrate with an organic layer and a first inorganic layer. The apparatus comprises a first and a second chamber and an atmosphere decoupling slot between the first and the second chamber. A deposition facility is arranged in the first chamber for depositing an organic layer and a vapor deposition facility is arranged in the second chamber for depositing the at least first inorganic layer at the substrate provided with the at least first organic layer. The flexible substrate is guided along the printing facility in the first chamber and via the atmosphere decoupling slot along the vapor deposition facility in the second chamber. The pressure in the first chamber is maintained in a range of 1 to 10 mbar, for example at 5 mbar. It is desirable to provide a deposition facility for deposition of an organic coating layer which is operable at a pressure below this range as such a deposition facility could be more easily integrated with a deposition facility for applying inorganic coating layers, for example by relaxing the requirements for the atmosphere decoupling slot, or even allowing the atmosphere decoupling slot to be replaced by a simple slit or even allowing both deposition facilities for inorganic coating layers and for organic coating layers to be arranged in a common chamber.

### SUMMARY OF THE INVENTION

It is an object of the present invention to provide a coating system having a coating apparatus, suitable for deposition of organic coating layers, which coating system can be more easily extended with at least another coating apparatus suitable for deposition of inorganic layers.

It is a further object of the present invention to provide a coating method including a coating step, suitable for deposition of organic layers, which coating method can be more easily extended with at least another coating step suitable for deposition of inorganic layers.

According to the first mentioned object, a coating system is provided as claimed in claim 1.

According to the second mentioned object, a coating method is provided as claimed in claim 14.

In the coating system and method according to the invention, a pressure inside the coating chamber is maintained at a level below 1 mbar. This makes it possible to arrange at least another coating apparatus suitable for deposition of inorganic layers in the same coating chamber. This renders possible deposition of multiple layers, including both inorganic layers and organic layers in a continuous deposition process. Until now, deposition of organic layers at low pressures was considered not feasible in view of expected complications, such as a lack of control of the flow of organic substance to be deposited arising from the lack of atmospheric backpressure. It was also considered that even if it were possible to provide a suitable deposition process at pressures below the above-mentioned level of 1 mbar, then such a deposition process would still not allow for an easy integration with deposition processes for inorganic coatings, due to contamination of the evacuated environment by organic substances. The inventors recognized that these complications can be avoided using proper measures, as further disclosed in more detail below.

As a first requirement, a curable organic precursor is used for preparation of the organic coating. I.e. an organic substance which is free from solvents. In particular photo-polymerizable substances are suitable for this purpose. Heat polymerizable substances could alternatively be used, but are less suitable, as they may tend to cure inadvertently in parts of the coating apparatus that are not sufficiently cooled. Moreover, photo-polymerizable substances, i.e. curable organic substances comprising photocurable compositions comprising at least one radically curable compound and radical photoinitiator are preferred, as they have the advantage that curing time is almost instantaneous.

The photocurable composition comprises one or more radically polymerizable compounds. The radically polymerizable compound is preferably ethylenically unsaturated, and is particularly preferably selected from compounds (monofunctional or polyfunctional compounds) having at least a terminal ethylenic unsaturated bond and more preferably two or more thereof. More specifically, it can be suitably selected from those widely known in the radiation curing industry, including those having a chemical structure of a monomer, a prepolymer (namely a dimer, a trimer, and an oligomer), a mixture thereof and a copolymer thereof. Detailed examples of such photocurable compositions can be found in WO2012057615.

The curable organic precursor to be deposited preferably has a viscosity in the range of 1 to 100 mPa.s, preferably in the range of 1 to 50 mPa.s.

The coating apparatus according to the first aspect includes a reservoir for the curable organic precursor. The coating system has a first operational mode wherein curable organic precursor in the reservoir is exposed to a vacuum having a pressure with a pressure value that is equal or lower than the pressure value in the chamber, preferably at least 10 times as small as the pressure value in the chamber where the organic coating is applied. Hence during the first operational mode the pressure in the reservoir should preferably be at least less than 0.1 mbar, as the pressure in the coating chamber is maintained at a value below 1 mbar. The pressure in the reservoir during the first operational mode however is preferably higher than about 0.001 mbar to avoid a substantial evaporation of curable organic precursor in this operational mode. In the first operational mode gases escape from the curable organic precursor. In case any solvents, or dissolved gases were present in the precursor, for example to allow handling thereof in a preparatory phase, these solvents or gasses are also removed in the first operational mode, at least to an extent that they do not complicate the coating process. During a second operational mode following the first operational mode, a pressure may be exerted to the curable organic precursor in the reservoir, for example a pressure of 100 mbar or higher. If this pressure is exerted by a gas, e.g. by N2, the pressure should not exceed a value of about 300 mbar to keep absorption of the pressurizing gas by the curable organic precursor at modest levels. Alternatively, a pressure may be exerted by a solid pressurizing means such as a piston, in which case a higher pressure may be applied. Also a higher pressure may be exerted by a pressurizing liquid which does not tend to mix with the curable organic precursor.

If the coating system includes a single reservoir for the curable organic precursor, the first operational mode precedes the operational mode wherein curable organic precursor is deposited on the substrate, and the second operational mode coincides with the operational mode wherein deposition takes place.

However, if the coating system includes more than one reservoir, the first and the second operational mode of a reservoir do not have to be synchronized with the operational mode wherein deposition takes place. For example a second reservoir may be in a first operational mode for degassing curable organic precursor therein, while the first coating reservoir delivers the curable organic precursor for the coating device.

The present invention allows for a roll to roll process allowing for subsequent deposition of both organic and inorganic layers, without requiring intermediate storage of the substrate to be coated. The transport velocity of the substrate may for example be in the order of 0, 5 to 50 m/min. A layer thickness of the organic materials may for example be in a range of thickness 1 to 50µm.

### BRIEF DESCRIPTION OF THE DRAWINGS

These and other aspects are described in more detail with reference to the drawing. Therein:
FIG. 1 shows a first embodiment of a coating system according to the first aspect of the invention,
FIG. 2 shows a second embodiment of a coating system according to the first aspect of the invention,
FIG. 3A shows a part of a third embodiment of a coating system according to the first aspect of the invention,
FIG. 3B shows a part of a fourth embodiment of a coating system according to the first aspect of the invention,
FIG. 3C shows a part of a fifth embodiment of a coating system according to the first aspect of the invention,
FIG. 3D shows a detail of the part of FIG. 3C,
FIG. 4A and 4B shows a respective operational state of a part of a sixth embodiment of a coating system according to the first aspect of the invention,
FIG. 5 shows a part of a seventh embodiment of a coating system according to the first aspect of the invention,
FIG. 6 partly shows an eighth embodiment of a coating system according to the first aspect of the invention,
FIG. 7 schematically shows a ninth embodiment of a coating system according to the first aspect of the invention,
FIG. 7A shows a part of said ninth embodiment in more detail,
FIG. 8 schematically shows a tenth embodiment of a coating system according to the first aspect of the invention,
FIG. 8A shows a part of said tenth embodiment in more detail,
FIG. 9 partly shows an eleventh embodiment of a coating system according to the first aspect of the invention,
FIG. 10 schematically shows an embodiment of a coating method according to the second aspect of the invention,
FIG. 11 partly shows a twelfth embodiment of a coating system according to the first aspect of the invention.

### DETAILED DESCRIPTION OF EMBODIMENTS

Like reference symbols in the various drawings indicate like elements unless otherwise indicated.

Unless otherwise defined, all terms (including technical and scientific terms) used herein have the same meaning as commonly understood by one of ordinary skill in the art to which this invention belongs as read in the context of the description and drawings. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In some instances, detailed descriptions of well-known devices and methods may be omitted so as not to obscure the description of the present systems and methods. Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be further understood that the terms "comprises" and/or "comprising" specify the presence of stated features but do not preclude the presence or addition of one or more other features. All publications, patent applications, patents, and other references mentioned herein are incorporated by reference in their entirety. In case of conflict, the present specification, including definitions, will control.

As used herein, the term "substrate" has its usual meaning in materials science as an object comprising a surface on which processing is conducted, in this case layer deposition. In this context, for example the production of flexible electronics, the substrate typically comprises a foil. The term "foil" refers to a sheet comprising one or more layers of material. The foil is flexible such that it can be used in a roll-to-roll (R2R) manufacturing process. For such purpose, a foil may be considered flexible if it can be rolled or bent over a radius of curvature of 50 cm or less, e.g. 12 cm, without losing its essential functionality, e.g. an electronic functionality. Alternatively, or in conjunction a foil may be considered flexible if it has a flexural rigidity smaller than 500 Pa·m³. Materials suitable for as the foil, or as a layer for the foil are for example polymers, such as PET, PEN or PI. Alternatively, metals may be used for this purpose, such as aluminum, steel or copper. The foil may for example have a thickness in the range of 1 micron to 1 mm depending on the required strength and flexibility.

As used herein, the term "coating" is used to indicate the process of applying a layer of material. The term "coating layer" indicates the layer of material covering a part of a substrate or intermediate layer. Typical for the coating layers as described herein is that they may be initially applied as a fluid or liquid to allow a degree of self-assembly or relocation of the coating after deposition, e.g. driven by differences in surface energy. After the coating layer achieves a desired patterning, the coating layer may be hardened, e.g. by curing and/or drying.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. The description of the exemplary embodiments is intended to be read in connection with the accompanying drawings, which are to be considered part of the entire written description. In the drawings, the size and relative sizes of systems, components, layers, and regions may be exaggerated for clarity. Embodiments are described with reference to cross-section illustrations that are schematic illustrations of possibly idealized embodiments and intermediate structures of the invention.

In the description, relative terms as well as derivatives thereof should be construed to refer to the orientation as then described or as shown in the drawing under discussion. These relative terms are for convenience of description and do not require that the system be constructed or operated in a particular orientation unless stated otherwise. It will further be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. It will further be understood that when a particular step of a method is referred to as subsequent to another step, it can directly follow said other step or one or more intermediate steps may be carried out before carrying out the particular step.

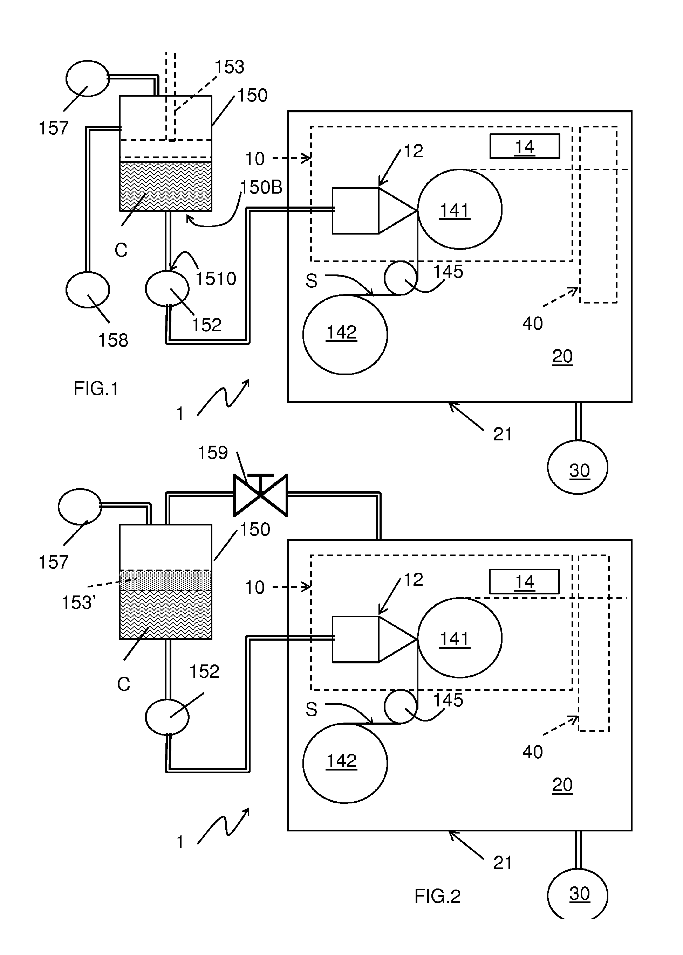

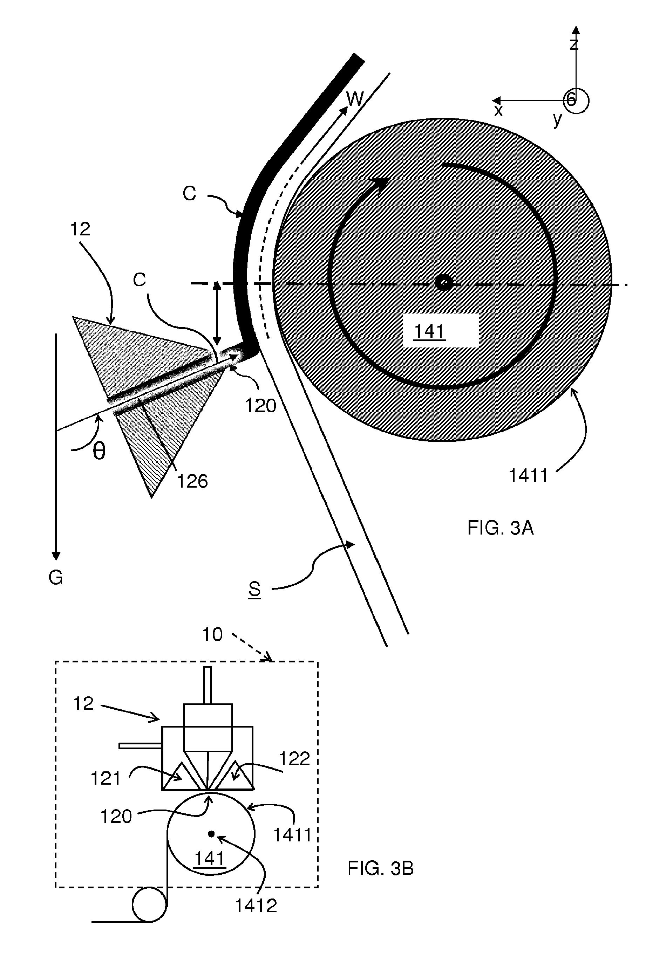

FIG. 1 schematically shows a coating system 1 that comprises a coating apparatus for depositing a coating layer of an organic material, such as a slot die coating apparatus 10, arranged in a coating chamber 20, bounded by walls 21. The slot die coating apparatus 10 comprises a coating device 12 to coat the curable organic precursor on a substrate S. As shown in more detail in FIG. 3A, in this embodiment, the coating device 12 includes a deposition slot 120 through which a curable organic precursor C is deposited on the substrate S. The slot die coating apparatus further comprising a transport facility, here including a transport roll 141 for transporting the substrate S along the coating device 12. The coating system 1 includes a vacuum pump 30 for evacuating the coating chamber 20. In an operational mode of the coating system 1 the vacuum pump maintains a pressure inside the coating chamber at a level below 1 mbar.

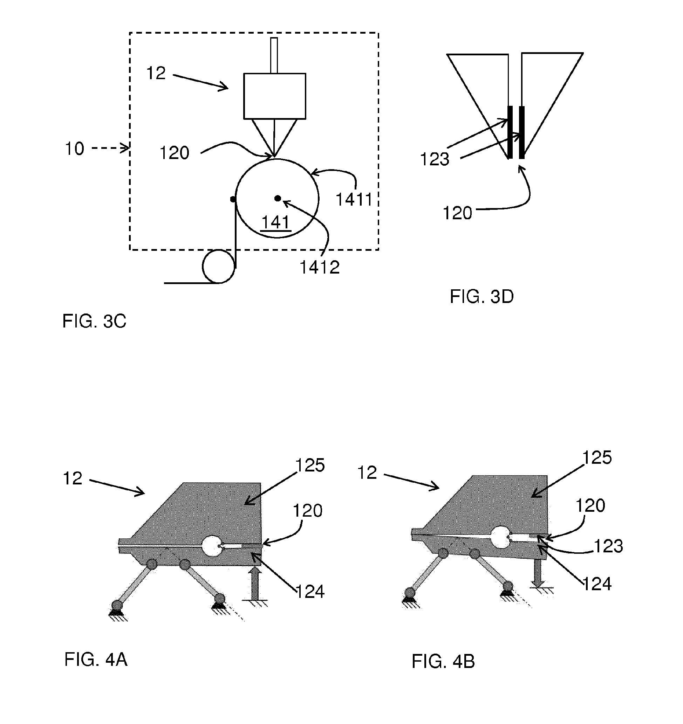

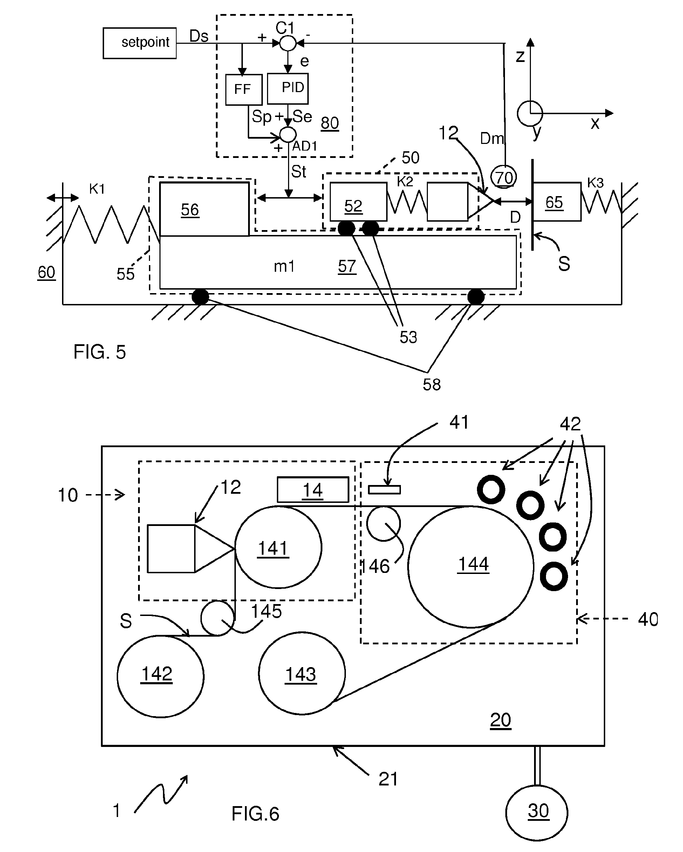

In the embodiment shown, the coating system 1 comprises, arranged in the coating chamber 20, a further coating apparatus 40, suitable for deposition of inorganic materials. The transport facility transports the substrate S from a feed roll 142 via the coating apparatus 10 and the further coating apparatus 40 to a storage roll 143. The transport facility may, apart from the transport roll 141, further include (See e.g. FIG. 3C and FIG. 6) a guidance roll 145 for guiding the substrate S from the feed roll 142 towards the transport roll 141, a guidance roll 146 for guiding the substrate S from the coating apparatus 10 to the further coating apparatus 40. The further coating apparatus 40, is for example a sputter coating device, or a vapor deposition device, such as a chemical vapor deposition device a physical vapor deposition device. As the organic coating apparatus 10 operates at a pressure lower than 1 mbar, the further coating apparatus 40 can properly function.

For clarity a coating system is illustrated with only one coating apparatus 10 and one further coating apparatus 40. In practice the coating system may include a larger numbers of coating apparatuses arranged in the coating chamber 20. For example the coating system may comprise a sequence of slot die coating apparatuses that are alternated by vapor deposition apparatuses, and the transport facility may transport the substrate via these coating apparatuses to provide a substrate that comprises a stack of inorganic and organic layers that alternate each other.

In the embodiment shown the transport facility transports the substrate S with a velocity which is for example greater than 0.5 m/min, for example of 1 m/min.

As shown in FIG. 1, the coating apparatus includes a reservoir 150 for the curable organic precursor C. The coating system has a first operational mode wherein curable organic precursor in the reservoir 150 is exposed to a vacuum in the range between 0.001 mbar and 1 mbar, in particular in the range of 0.005 mbar to 1 mbar, e.g. 0.01, 0.1 or 1 mbar. This pressure is maintained during several hours, for example during 5 to 10 hours. In this operational mode gases solved in the curable organic precursor are expelled. This process may be accelerated by stirring the curable organic precursor, e.g. with a blade in the reservoir. Alternatively, the curable organic precursor may be circulated by an external pumping system, preferably by pumping curable organic precursor from the bottom 150B of the reservoir back to the top of the reservoir. Subsequently, in the second operational mode, a pressure of at least 100 mbar is exerted to the curable organic precursor in the reservoir. In the embodiment shown this is achieved by supplying via pressurizing gas supply 157 a pressurizing gas, which is preferably an inert gas, such as N2 or a noble gas. In order to mitigate that pressurizing gas is absorbed by the curable organic precursor, the pressure is preferably below 300 mbar, for example about 200 mbar. As shown by dotted lines in FIG. 1, also other means may be applied to apply pressure, such as a piston 153. Additionally or alternatively the curable organic precursor may be pressurized in a conduit towards the coating device 12 by gravity, i.e. by arranging the reservoir 150 at a sufficient height.

In the embodiment of FIG. 1, the pressure in the reservoir 150 and the pressure in the coating chamber 20 are controlled by separate vacuum pumps 158 and 30 respectively.

FIG. 2 shows an alternative embodiment, wherein the coating system includes a controllable valve 159 for controllably connecting the coating chamber 20 with the reservoir. The controllable valve 159 is held open during the first operational mode and held closed during the second operational mode. Hence in the first operational mode both the atmosphere above the curable organic precursor C and the coating chamber are evacuated by the vacuum pump 30 to the above-mentioned pressure in the range of 0.001 mbar and 1 mbar, in particular in the range of 0.005 mbar to 1 mbar, e.g. 0.1 mbar. Subsequent to closure of the controllable valve 159 the pressure of the atmosphere above the curable organic precursor C and the pressure of the atmosphere in the coating chamber are independently controlled by the pressurizing gas supply 157 and the vacuum pump 30 respectively.

In the embodiment of FIG. 2 and 3, the supply facility includes a pump 152. The pump 152 is arranged to pump the curable organic precursor C from the reservoir 150 to the coating device 12 during a first operational mode, and is arranged to pump curable organic precursor in the reverse direction in a second operational mode. This allows for a better control of a flow of the curable organic precursor as delivered by the coating device in the evacuated chamber 20. Various other measures may be provided for further improval of this flow-control, as illustrated in FIGs. 3A-3D and FIG. 4A, 4B for example.

As a first example, FIG. 3A shows an embodiment wherein a deposition opening 120 for supplying the curable organic precursor C is arranged at a position below a position where the curable organic precursor is deposited on the substrate S. In particular, it can be observed in FIG. 3A that a rotation axis 1412 of the coater roll 141 along the outer surface 1411 of which the substrate S is transported is arranged above the deposition slot 120 of the coating device 12 facing the coater roll 141. Furthermore a channel for the curable organic precursor C has a slope θ upward towards the deposition slot 120.

FIG. 3B shows a second example, wherein the coating device 12 further includes a first and a first pressure chamber 121, 122 arranged on mutually opposite sides of the deposition slot 120. During the second operational mode of the pump, these pressure chambers jet a stream of gas in the direction of the deposition slot 120. Therewith the pressure is locally increased in the environment of the deposition slot, therewith exerting a backpressure on the curable organic precursor C to prevent a further flow out of the deposition head. FIG. 3B shows that it is not necessary that the curable organic precursor is deposited from a lower position. Nevertheless, the measures of FIG. 3B and FIG. 3A may be combined by a replacement of the coating device 12 in the arrangement of FIG. 3A with the coating device 12 shown in FIG. 3B.

FIG. 3C and 3D show again another arrangement. Therein FIG. 3D shows a detail of the coating device 12 of FIG. 3C. In this arrangement a boundary 123 of the deposition slot 120 has a surface energy that is low with respect to the curable organic precursor. The boundary may be applied as a separate rim, but that is not necessary. In particular the surface energy is at most 20 mN/m. As an example the boundary 123 of the deposition slot 120 may be formed by a material as Polytetrafluoroethylene (PTFE) or by a metal coated therewith to achieve the relatively low surface energy. As another example, a SAM layer of fluoro-octyl-trichloro-silane (FOTS) may be applied having a surface energy of 17 mN/m. The deposition slot 120 of FIG. 3D may be applied also in the arrangement of FIG. 3A or FIG. 3B, or in the arrangement of FIG. 3A having the coating device 12 of FIG. 3B.

FIG. 4A, 4B illustrates another example of a coating device 12 particularly suitable for use. In this embodiment, the coating device 12, here a coating device 12 of a slot die coating apparatus, includes a first and a second part 124, 125 that bound the deposition slot 120 at mutually opposite sides. The first and the second part 124, 125 are displaceable with respect to each other and therewith provide for an alternative or additional means for controlling a flow of the curable organic precursor. FIG. 4A shows a first state of the coating device 12, wherein the first and the second part 124, 125 are pressed against each other to close the deposition slot 120. FIG. 4B shows a first state of the coating device 12, wherein the first and the second part 124, 125 are displaced from each other to open the deposition slot 120. In the embodiment shown, as an option, a surface of the second part 125, that bounds the deposition slot 120, is provided with a boundary 123 as described with reference to FIG. 3C and 3D. The head of FIG. 4A, 4B, optionally having a boundary 123, may be applied also in the arrangement of FIG. 3A or FIG. 3B, or in the arrangement of FIG. 3A having the coating device 12 of FIG. 3B.

In the embodiment shown in FIG. 5 the coating apparatus includes a positioning unit to position the coating device 12 at a controllable distance D with respect to said substrate S. The positioning unit is arranged to position the coating device 12 at a first distance with respect to the substrate in a first positioning mode and at a second distance with respect to said substrate S in a second positioning mode, the first distance being smaller than the second distance.

In an arrangement having the reversible pump 152, the first positioning mode at least substantially coincides with the first operational mode of the pump and the second positioning mode at least substantially coincides with the second operational mode of the pump.

In the apparatus of FIG. 5, reference numeral 65 denotes a substrate carrier 65, e.g. in the form of a coater roll 141, as shown in more detail in FIG. 1,2 or 3A, for carrying the substrate S.

In this embodiment the apparatus comprises a coating device with at least a head-side unit and a support-side unit 50, 55 that are mutually movable with respect to each other by at least one motor 52, 56.

The head-side unit 50 comprises a translator part 52 of the at least one motor and a slot-die coating device 12. The slot-die coating device 12, comprises an outflow opening from which outflow opening, in use, flows a curable organic precursor. The outflow opening forms a slit that is, in use, arranged in a slit direction y over the substrate surface S.

The at least a support-side unit 55 comprising a stator part 56 of the at least one motor.

The apparatus comprises a sensor facility 70 for measuring a distance D between the outflow opening of the coating device 12 and the substrate surface in a translation direction x transverse to the slit direction y. The sensor facility 70 provides a sense signal indicative for a measured value of the distance D. Alternatively the sensor facility may measure a distance to the surface of the substrate carrier 65. In that case the distance to the substrate surface may be determined by subtraction of the thickness of the substrate from the measured distance.

A controller 80 is provided that is arranged for controlling the at least one motor 52, 56 in accordance with an input signal Ds indicative for a desired value of the distance D and the sense signal Ds, in order to position the slot-die coating device 12 at a distance having the desired value.

Relative movement between the first part 50 and the second part 55 is facilitated by a bearing 53, e.g. an air-bearing or an elastic bearing. Relative movement between the second part 55 and the support 60 is facilitated by a further bearing 58, e.g. an air-bearing or an elastic bearing.

The at least a support-side unit 55 has a mass that is at least equal to the mass of the at least a head-side unit 50 and the at least a support-side unit 55 is flexibly coupled to the support 60. The spring constant K1 of the coupling is for example selected in a range from 100 to 100.000 N/m, preferably in arrange from 1000 to 50.000 N/m. For comparison, the spring constant K2 of the mechanical coupling between the translator part 52 of the motor and the coating device 12, typically has a substantially higher value, e.g. in the order of 10E8 - 10E10 N/m. Also the spring constant K3 for the mechanical coupling between the substrate carrier 65 and the support 60 has a substantially higher value, e.g. in the order of 10E6 - 10E8 N/m.

By way of example the support-side unit 55 including the stator 56 and the additional mass 57 has a mass m1 of about 250 kg. The translator 52 of the motor each and the coating device 12 each have a mass of 25 kg. Accordingly, the mass of the support-side unit 55 is 5 times higher than the mass of the head-side unit 50. The mass of the substrate carrier 65 is 100 kg. The weight of the floor, which serves as the support 60 is estimated to have a weight of 10,000 kg.

Typically a higher stiffness is used for the coupling K1 if the mass of the support-side unit 55 is higher. A ratio for the stiffness K1 divided by the mass of the support-side unit is for example in the range 10 - 100 s⁻², in this case 40 s⁻².

In an embodiment as shown in FIG. 1, an additional mass 57 is tightly coupled to the stator part 56 of the motor. However, alternatively the stator part 56 may be designed to have a relatively large mass itself, therewith obviating a separate mass.

The controller 80 has a feedback control section PID for generating a first control signal Se on the basis of the difference e between the specified value Ds and the measured value Dm of the distance. The controller 80 also has a feed forward control section FF for generating a prediction control signal Sp on the basis of the specified value Ds. The sum signal St obtained by add unit AD1 from the signals Se, Sp of the feedback control section PID and the feed forward control section FF is used to control the motor. The controller may further have an adaptation section for improving the accuracy and response time based on the observed behavior of the system.

FIG. 6 shows an embodiment of the coating system 1, wherein the further coating apparatus 40 is a vapor deposition apparatus. In the embodiment shown the further coating apparatus 40 comprises a plasma cleaning unit 41 and evaporation devices 42. A guidance roll 146 is provided for guiding the substrate S from the coating apparatus 10 to the further coating apparatus 40. The transport facility also includes a drum 144 for transporting the substrate within the further coating apparatus 40 to the storage roll 143. As the coating apparatus 10 operates at a pressure lower than 1 mbar, the further coating apparatus 40 can properly function.

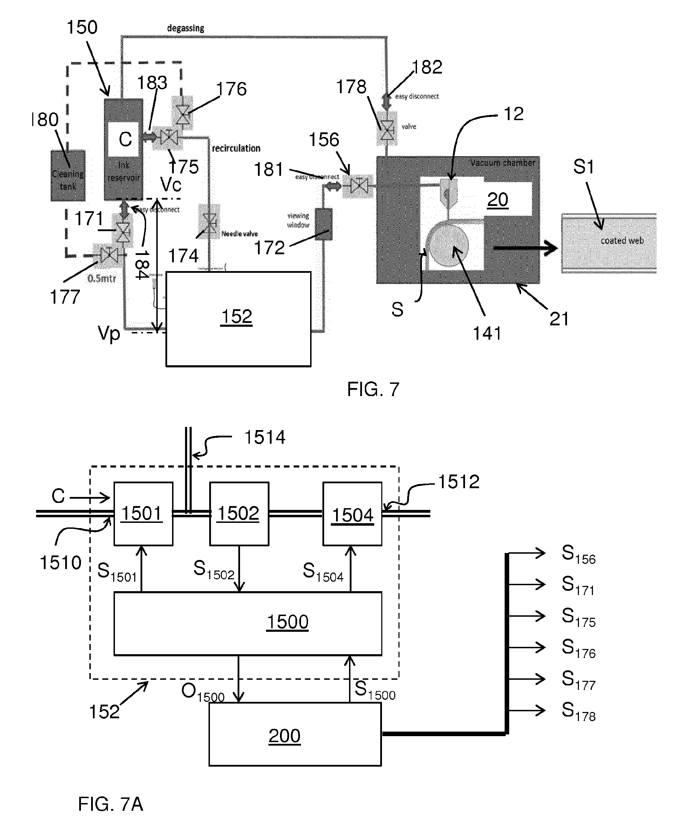

FIG. 7 schematically shows a coating system for coating a substrate S to obtain coated substrate S1. For clarity only part of the coating apparatus for applying the organic coating layer is shown. Also for clarity no further coating apparatus is illustrated in FIG. 7. FIG. 7 shows in more detail a supply arrangement for supplying curable organic precursor C to the coating device 12.

In the embodiment shown, the supply arrangement includes a reservoir 150 for storing a volume of curable organic precursor C. During normal operation valve 171 is in an open state, and curable organic precursor C is allowed to flow towards pump unit 152, an embodiment of which is shown in more detail in FIG. 7A. In the embodiment shown, the pump unit 152, in addition to a pump 1501, may comprise a filter, a flow meter 1502, a control valve 1504 and a controller 1500 for controlling the control valve and the pump 1501 to achieve a desired flow rate of the curable organic precursor C. The reservoir 150 is arranged with its bottom a distance Vc above an input of the pump unit 152, therewith allowing curable organic precursor C to flow towards the pump unit 152 despite the low pressure in the reservoir 150. The pump-unit 152, pumps the curable organic precursor C to the coating device 12, via controllable valve 156, which in this operational mode is also in an open state. A recirculation path is provided that recirculates a surplus of curable organic precursor C from the pump unit 152 via needle valve 174 and controllable valve 175 back towards the reservoir 150. As a result of this recirculation a curable organic precursor C from the bottom of the reservoir is permanently guided towards the upper part of the reservoir, where remaining gases in the curable organic precursor C can easily escape. In this operational mode, wherein curable organic precursor C is pumped to the coating device 12, the valves 176, 177, 178 are kept closed. In an different operational mode, the valves 176, 176 are opened, while valves 171 and 175 are kept closed, therewith allowing a cleaning liquid contained in a further reservoir 180 to circulate through the pump unit 152 and if necessary also towards and through the coating device 12. For degassing purposes, to be performed before normal operation, the valve 178 is opened to allow an evacuation of the atmosphere above the surface of the curable organic precursor in reservoir 150. During degassing, the pump unit 152 may be used to circulate the curable organic precursor via the recirculation path, therewith accelerating the degassing process. As an alternative the curable organic precursor C may be circulated internally for example by a rotating blade arranged inside the reservoir 150. For maintenance, various parts of the arrangement of FIG. 7 can rapidly be decoupled by detachable coupling elements 181, 182, 183, 184.

The pump 1501 can be a gear pump, eccentric disc pump or other type of continuous flow pump suited for vacuum applications. In the embodiment shown the pump 1501 used in the pump unit 152 is a gear pump. This type of pump is suitable to provide a highly regular flow. However, as a result of friction between the gears in the gear pump, heat is developed. Due to a lack of oxygen inhibition in the degased curable organic precursor, the curable organic precursor easily tends to cure under these circumstance, having the result that the pump is jammed. In order to avoid this, is would be necessary to cool the pump, either directly, or by delivering the curable organic precursor in a cooled state to the pump.

FIG. 7A shows the pump unit 152 in more detail. As illustrated therein, the pump unit 152 includes a controller 1500 which in operation controls the pump 1501 with control signal S₁₅₀₁. The pump 1501 receives curable organic precursor C that enters the pump unit 152 via input 1510 and pumps the curable organic precursor C via flow meter 1502 and flow control valve 1504 to a primary output coupled to the coating device 12, here via the elements 172, 181 and 156 specified above. The flow meter 1502 provides a flow magnitude signal S₁₅₀₂, indicative for a magnitude of the flow to controller. In the embodiment shown the flow meter 1502 is a Coriolis flow meter, which is advantageous in that it measures the flow in a contact-less manner. This facilitates maintenance and cleaning. The controller 1500, e.g. a PID controller uses the signal S₁₅₀₂, to provide a control signal S₁₅₀₄ to flow control valve 1504, therewith allowing curable organic precursor C to flow towards the coating device 12 at a flow rate close to a predetermined value. As shown in FIG. 7A, the pump unit 152 has a secondary output 1514 which allows the surplus of curable organic precursor to flow back to the reservoir 150 via needle valve 174 and valve 175.

As further shown in FIG. 7A, the controller 1500 is controlled by a master controller 200 with control signals S₁₅₀₀. The master controller 200 may also receive output signals O₁₅₀₀ from the controller 1500. The master controller 200 also may control various other components of the coating system, for example the master controller 200 may control the valves 156, 171, 175, 176, 177 and 178 by respective control signals S₁₅₆, S₁₇₁, S₁₇₅, S₁₇₆, S₁₇₇ and S₁₇₈, as schematically shown in FIG. 7A.

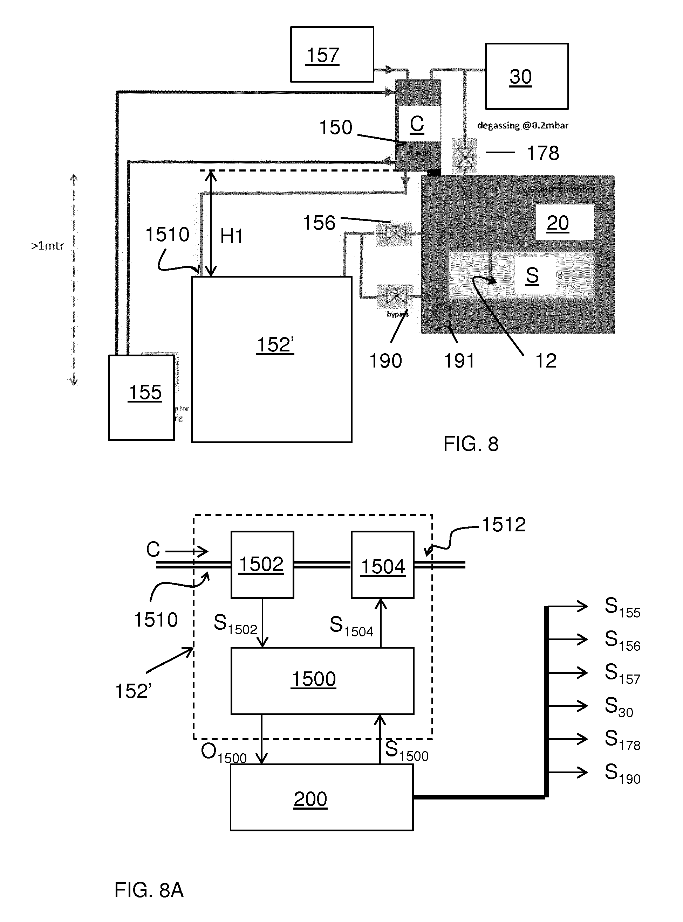

An alternative embodiment of the system is shown in FIG. 8 having a supply unit 152', shown in more detail in FIG. 8A, for supplying curable organic precursor C to the coating device 12. Contrary to the pump unit 152 in the embodiment of FIG. 7, the supply unit 152' does not include a pump. Instead, in this embodiment the pressurizing gas supply 157 applies a pressure on the curable organic precursor C by an inert gas, for example N2 or a noble gas. The gas pressure may be in a range of 0.01 bar to 0.3 bar, for example 0.2 bar depending on a pressure in the coating chamber 20. As a result of the pressure applied to the curable organic precursor, and the slight height difference the curable organic precursor can be supplied at a sufficient flow rate, as controlled by components 1500, 1502, 1504, to the coating device 12.

The arrangement shown in FIG. 8 further differs from the arrangement in FIG. 7, in that a separate circulation pump 155 is provided for circulating curable organic precursor C from a bottom part of the reservoir 150 to an upper part of the reservoir, where at a surface of the curable organic precursor C present in the reservoir. The circulation pump 155 can be a peristaltic or excentric disc pump or other type of pump suited for vacuum applications. In this case the recirculation pump 155 is a peristaltic pump. It has been found that this type of pump does not tend to jam due to unintended curing of curable organic precursor therein, even if it is not specifically cooled. In addition, in this embodiment a bypass is provided that is coupled via a controllable valve 190 to a reservoir 191 accommodated in the coating chamber 20. Upon startup of the system, some gas bubbles may be present in the curable organic precursor C. In this stage the bypass can be used to allow the curable organic precursor C to flow to the tank 191, therewith avoiding that it flows to the coating device 12 and would result in an unreliable coating process.

As in the embodiment of FIG. 7, 7A the controller 1500 is on its turn controlled by a master controller 200, which also controls various other components of the system, such as peristaltic pump 155, pressurizing gas supply 157, vacuum pump 30, and valves 156, 178 and 190 by respective control signals S₁₅₅, S₁₅₇, S₃₀, S₁₅₆, S₁₇₈ and S₁₉₀.

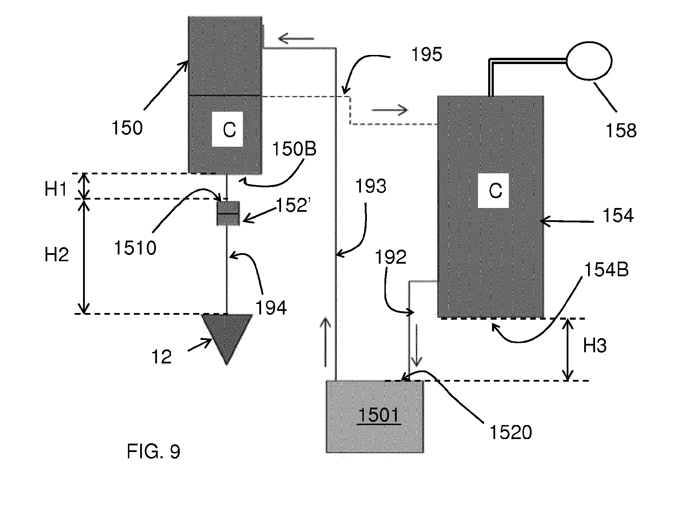

FIG. 9 shows some aspects of another arrangement. Therein the reservoir 150 is provided at a height H1 above the supply facility 152' which on its turn is arranged at a second height H2 above the coating device. The sum H1+H2 of the first and the second height should be sufficiently large in order to provide a supply of curable organic precursor via conduit 194 to the coating device 12 at a sufficient flow rate, as controlled by supply unit 152', without requiring additional measures to pressurize the curable organic precursor. The sum H1+H2 is for example at least 3 m. The supply unit 152'may be similar to the supply unit 152' as shown in FIG. 8A for example. Here the pumping unit 1501 is provided to pump the curable organic precursor C via conduit 192 from the further reservoir 154 to the reservoir 150 via conduit 193. The reservoir 150 is arranged at height H1, less than the sum of H1+H2, for example 1m, above the pump 1501, to allow gravity forces to induce a flow of the coating fluid C to the pump 1501. As shown in FIG. 9 an overflow conduit 195 is provided for allowing a flow of curable organic precursor from the reservoir 150 back to the further reservoir 154. This overflow conduit 195 serves a dual purpose. In the first place, therewith the fluid level of the curable organic precursor C in the reservoir 150 is maintained at a constant level. Therewith also the fluid pressure at the input 1510 of the supply unit 152' is maintained constant, facilitating control of a constant flow of curable organic precursor to the coating device 12. In the second place, curable organic precursor C is recirculated from the bottom of the further reservoir 154 via conduit 192, the pump 1501, the conduit 193, the reservoir 150 and the overflow conduit 195 back to the top of the further reservoir 154. As mentioned above, this provides for an improved degassing of the curable organic precursor C. It is noted that the pump 1501 does not need to provide a constant flow of curable organic precursor in this embodiment, as long as an average magnitude with which it delivers curable organic precursor to the reservoir 150 exceeds the flow rate to be supplied to the coating device 12. Accordingly, even a peristaltic pump, which provides a clearly pulsating flow would suffice.

As an alternative for the overflow conduit 195, a feedback circuit may be used that controls operation of the pump 1501 depending on a level of the curable organic precursor in the reservoir 150, so as to maintain the level at a substantially constant height.

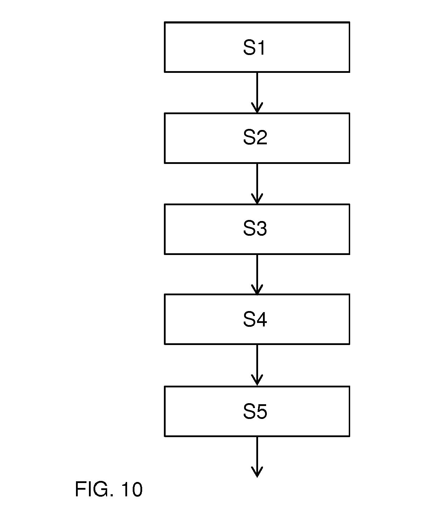

FIG. 10 schematically illustrates a method according to the second aspect of the invention. The exemplary method comprises a first step S1, wherein a curable organic precursor (C) is exposed to a vacuum having a first pressure, for example a pressure in the range of 0.001 mbar and 1 mbar, e.g. 0.1 mbar. The first pressure may be maintained by a dedicated vacuum pump, for example pump 158, as shown in FIG. 1. Alternatively a shared vacuum pump may be used that also serves to evacuate and/or maintain evacuated a deposition chamber, such as the vacuum pump 30 in FIG. 2 or FIG. 8. In this first step S1 the curable organic precursor is degassed. During this first step S1, the curable organic precursor may be circulated for example by stirring the curable organic precursor in a reservoir wherein the curable organic precursor is degassed. Alternatively curable organic precursor may be circulated in the reservoir by pumping the organic precursor from a volume of said curable organic precursor at a lower level in said reservoir to a surface level of said volume in said reservoir, while exposing the surface level of said volume of said curable organic precursor to the vacuum having the first pressure. This is for example shown in FIG. 7. The pumping unit 152 therein circulates the curable organic precursor in reservoir 150. Likewise in the embodiment of FIG. 8 the pump 155 circulates the curable organic precursor in reservoir 150. In the embodiment the pump 1501 circulates the curable organic precursor in further reservoir 154. In an embodiment a volume of about 1 to 10 liter curable organic precursor in is degassed in couple of hours. Therewith the curable organic precursor was circulated by pumping it at a flow rate of about 10 to 200 ml/min. As a result of step S1 the curable organic precursor is degassed, and any solvents and or dissolved gases which might have been present in the curable organic precursor are also removed at least to an extent that they do not complicate the coating process in the chamber 20..

Subsequent to said first step S1, in a second step S2, the degassed curable organic precursor is supplied to a coating device 12 (e.g. a deposition slot or a print head) of a coating apparatus 10, which is arranged in an evacuated chamber 20, i.e. having a pressure below 1 mbar, for example of about 0.15 mbar. The pressure in the reservoir 150 or 154 during the first step S1 less than or equal to, the pressure in the chamber 20 during the second step S2. More in particular, the degassing pressure during step S1 in the reservoir 150 is more than 10 times as small as the chamber pressure during step S2 in the chamber 20, here 15 times as small. Subsequent to the first step S1, the pressure inside the reservoir with the curable organic precursor may be increased, but the pressure is preferably maintained at a relatively low level, e.g. below 300 mbar to avoid that gas is absorbed again in the curable organic precursor. The curable organic precursor is controllably supplied to the coating device 12, by a pump unit 152 or a supply unit 152' which should have its input a distance H1, e.g. of 1 m, below a bottom 150B of the reservoir. The flow of curable organic precursor towards the coating device 12 may be induced solely by gravity and further controlled by supply unit 152', as shown in FIG. 9. In this case, where only gravity is used to induce the flow, the distance H1+H2 should be relatively large, e.g. 3 m or more. Alternatively, a pressure may be exerted on curable organic precursor in the reservoir, for example by an inert gas inserted by a pressuring gas supply 157, as shown in FIG. 1, 2 and 8. When exerting a pressure in this manner a surface of the curable organic precursor in the reservoir may be covered by a plate 153', as shown in FIG. 2, to prevent absorption of the pressurizing gas in the liquid. Alternatively a pressure may be exerted by a piston 153, as shown in FIG. 1. When exerting an additional pressure by a pressurizing gas or by a piston, the height of the bottom 150B of the reservoir 150 can be modest, provided that it exceeds a height of the input of the pump 152 or the supply unit 152', e.g. by about 1m. If a pump 152 is provided it is not necessary to exert a pressure, but still the height of the bottom 150B of the reservoir 150 should exceeds a height of the input of the pump 152, for example by 1 m. Therewith, it should be taken into account that degassed curable organic precursor may inadvertently cure in the pump if the latter is not sufficiently cooled. The pump unit 152 or the supply unit 152' provide for a controlled flow of degassed curable organic precursor to the coating device, for example at a flow rate of 1 to 100 ml/min, depending on a transport speed of the substrate, the size of the substrate and a required thickness of the organic coating layer thereon. By way of example the substrate has a width of about 50 cm, its transport velocity is 1 m/min and the flow rate is 10 ml/min, so as to achieve a coating layer thickness of about 20 micron.

In a third step S3, which in practice coincides with the second step S2 the coating device 12 deposits the degassed solvent free organic precursor on the substrate S which is meanwhile transported along the coating device towards a curing station 14.

In a fourth step S4 the solvent free organic precursor deposited on the substrate is cured by supplying energy with the curing station 14 to the curable organic precursor, therewith obtaining an organic coating layer on the substrate S. Depending on the type of curable organic precursor that was deposited, curing may be effected by heating the curable organic precursor or by irradiating the curable organic precursor with photon radiation. In the present embodiment the curable organic precursor is a photo-polymerized (radical polymerization e.g. using acrylic groups) by UV-radiation at a wavelength of 365 nm at a curing dose of about 40mJ/cm2. As the method according to the second aspect is a roll to roll process, it will be understood that in fact the step S4 of curing depositing curable organic precursor coincides with the step S3 of depositing curable organic precursor on a fresh part of the substrate S.

Subsequent or before applying the organic coating layer on the substrate, an inorganic coating layer can be applied as a fifth step S5, for example with a vapor deposition apparatus 40, as shown in and described with reference to FIG. 6. In the embodiment of FIG. 6 the vapor deposition apparatus 40 is arranged "stream downwards" so that it applies the inorganic coating layer on top of the organic coating layer. Alternatively, or in addition a further coating apparatus for applying an inorganic coating layer may be applied arranged stream upwards with respect to the coating apparatus, therewith providing an inorganic coating layer upon which the organic coating layer is provided. In fact an arbitrary number of coating apparatuses of the type of apparatus 10 for applying an organic coating layer and apparatuses of the type of apparatus 40 for applying an inorganic coating layer may be arranged in a sequence, wherein the transporting system transports the substrate along these various coating apparatuses. As the deposition steps are performed in a roll to roll process the steps S2, S3, S4 to deposit organic coating layers and the steps S5 for inorganic coating layers all coincide. As the coating apparatuses of the type of apparatus 10 operate at a low pressure they can be easily combined with the coating apparatuses for depositing inorganic coating layers. In practice less strict requirements for separation of these both types of coating apparatuses are necessary. In practice it is sufficient to separate these apparatuses by a simple wall having a letter box shaped opening for passing the substrate.

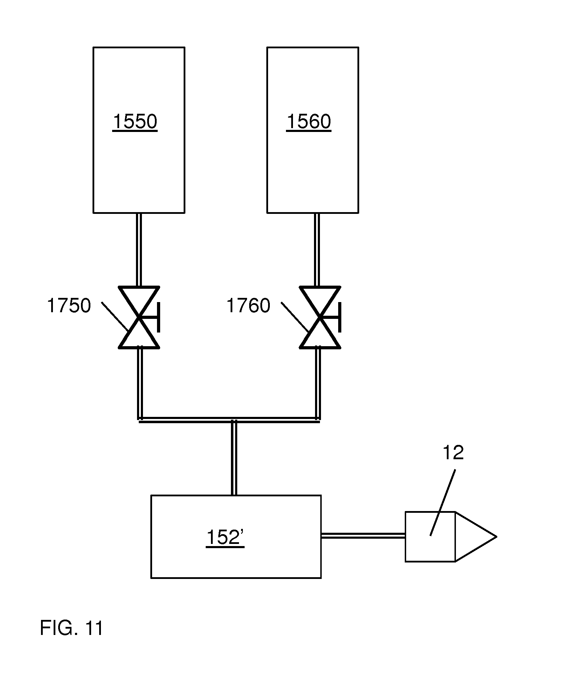

It is noted that step S1 may also coincide with the other steps S2, S3, S4 and S5, provided that the coating apparatus for providing the organic coating layer comprises an additional supply for the curable organic precursor. This is schematically shown in FIG. 11. During a first time period the reservoir 1550 provides degassed curable organic precursor via open valve 1750 and supply unit 152' to coating device 12. During this first time period the second valve 1760 is closed, and the reservoir 1560 is filled with curable organic precursor which is subsequently degassed during the remainder of the first time period. At the end of the first time period the reservoir 1560 provides degassed curable organic precursor via open valve 1760 and supply unit 152' to coating device 12, while reservoir 1550 is filled with curable organic precursor which is subsequently degassed. This process can be repeated so as to provide a continuous supply of degassed curable organic precursor to the coating device 12.

## Claims

1. Coating system (1) comprising a coating chamber (20) having arranged therein a coating apparatus (10) for providing a substrate (S) with an organic coating layer, the coating apparatus (10) comprising a coating device (12) for depositing a solvent free, curable organic precursor for said organic coating and a curing unit (14) for curing the organic precursor deposited on said substrate (S) by supplying energy to said organic precursor, the coating system further comprising a vacuum pump (30) for in an operational mode of the coating system maintaining a pressure inside said coating chamber at a chamber pressure value being less than 1 mbar, a transport facility (141) for transporting the substrate along the coating apparatus, a reservoir (150) for the curable organic precursor, and a supply facility (152, 152') for controllably supplying the curable organic precursor from said reservoir to said coating device, said supply facility (152, 152') having an input (1510) for receiving curable organic precursor from the reservoir, wherein a position of a bottom (150B) of said reservoir is arranged at a height (H1) above said input (1510), the coating system having a first operational mode wherein curable organic precursor to be supplied to the coating apparatus is exposed to a vacuum having a pressure with a first pressure value that is equal to lower than the chamber pressure value, and having a second operational mode following the first operational mode, wherein said supply facility (152, 152') supplies the curable organic precursor to the coating device.

2. Coating system (1), wherein said first pressure is has a value in the range between 0.001 mbar and 0.1 mbar.

3. Coating system (1) according to claim 1, comprising in addition to said coating apparatus (10) for providing a substrate with an organic coating layer, a further coating apparatus (40) for providing the substrate with an inorganic coating layer, wherein said transport facility (141) further transports the substrate from the coating apparatus (30) to the further coating apparatus (40) or from the further coating apparatus (40) to the coating apparatus (30).

4. Coating system according to claim 3, wherein said coating apparatus (10) and said further coating apparatus (40) are arranged in a common chamber (20).

5. Coating system according to either one of the previous claims, further comprising a pressuring gas supply (157), which pressuring gas supply is arranged to apply a gas pressure in said reservoir (150) with an inert gas at a pressure in a range between 100 and 300 mbar.

6. Coating system according to either of the previous claims, comprising a further reservoir (154), a pump (1501) being provided to pump the curable organic precursor (C) from the further reservoir (154) to the reservoir (150), wherein said supply facility (152') is arranged at a second height (H2) above said coating device (12), wherein said further reservoir (154) has a bottom (154B) arranged at a third height (H3) above an input (1520) of said pump (1501 and wherein said third height (H3) is less than a sum of said first height (H1) and said second height (H2).

7. Coating system according to claim 6, comprising an overflow conduit (195) for allowing a flow of curable organic precursor from the reservoir (150) back to the further reservoir (154).

8. Coating system according to either one of the previous claims, wherein said coating device (12) includes a deposition slot (120) and a first and a second pressure chamber (121, 122) arranged on mutually opposite sides of the deposition slot (120), which are provided to jet a stream of gas in the direction of the deposition slot in said second operational mode.

9. Coating system according to either one of the previous claims, wherein the deposition head includes a deposition slot (120), a surface area (123) of the deposition head bounding the deposition slot having a surface energy that is low with respect to the curable organic precursor.

10. Coating system according to claim 9, wherein said surface energy is at most 20 mN/m.

11. Coating system according to either one of the previous claims, wherein the coating device (12) includes a first and a second part (124, 125) that bound a deposition slot (120) at mutually opposite sides and that are displaceable with respect to each other to control a flow of the curable organic precursor, wherein the coating apparatus is arranged to operate intermittently by controlling the flow with said displacement

12. Coating system according to either one of the previous claims, wherein the coating apparatus includes a positioning unit to position the coating device (12) at a controllable distance with respect to said substrate (S), the positioning unit being arranged to position the coating device (12) at a first distance with respect to said substrate (S) in a first positioning mode and at a second distance with respect to said substrate (S) in a second positioning mode, the first distance being smaller than the second distance.

13. Coating system according to one of the previous claims, wherein said coating system includes an additional vacuum pump (158) for providing the vacuum to which the curable organic precursor in the reservoir is to be exposed in the first operational mode.

14. Method of coating a substrate (S), the method including the steps of
- exposing a curable organic precursor to a vacuum having a first pressure,
- supplying curable organic precursor to a coating device of a coating apparatus, which is arranged in an evacuated chamber, the curable organic precursor being substantially free from solvents and dissolved gases when it is supplied to the coating device,
- depositing the solvent free, curable organic precursor on the substrate, while transporting the substrate in said coating chamber along the coating device,
- curing the curable organic precursor deposited on the substrate by supplying energy to the curable organic precursor, therewith obtaining an organic coating layer on the substrate,
wherein a chamber pressure in said evacuated chamber is less than 1 mbar, and wherein said first pressure is equal to or lower than said chamber pressure.

15. Method of coating a substrate according to claim 14, comprising circulating curable organic precursor in a reservoir by pumping the organic precursor from a volume of said curable organic precursor at a lower level in said reservoir to a surface level of said volume in said reservoir, while exposing the surface level of said volume of said curable organic precursor to the vacuum having the first pressure.
